# EUROPEAN PATENT APPLICATION

(11) **EP 1 857 790 A2**
(43) Date of publication of application: **21.11.2007**
(21) Application number: 07100618.3
(22) Date of filing: 16.01.2007
(51) Int. Cl.: G01J 3/10, G01J 1/58

(54) **Illumination source including photoluminescent material and a filter, and an apparatus including same**

(30) Priority: 15.05.2006 US 434601
(71) Applicant: X-Rite, Incorporated, MI 49512A MI Michigan Grandville (US)
(72) Inventor: Bylsma, Richard B., Ada, Michigan MI 49301 (US)
(74) Representative: Finnie, Peter John

(57) **Abstract**

A illumination source (10) comprising a light emitting device (12), at least one photoluminescent material layer (20), and a filter (19) between the light emitting device (12) and the photoluminescent material layer (20). The light emitting device (12) may comprise one or more LEDs, one or more lasers, one or more laser diodes, one or more lamps, or a combination of these things. The photoluminescent material layer (20) may comprise quantum dot material and/or phosphors, and it may absorb light emitted from the light emitting device (12) and convert the wavelengths of at least a portion of the photons emitted from the light emitting device (12) to longer wavelengths. The filter (19) may be substantially transmissive of light emitted by the light emitting device (12) and substantially reflective of light emitted by the photoluminescent material layer (20), which may be omnidirectional. That way, light emitted from the light emitting device (12) and the photoluminescent material layer (20) may be directed in a common direction that is generally away from the light emitting device (12). The properties of the photoluminescent material layer (20) may be chosen to achieve a desired emission spectra for the illumination source (10).

## Description

### Background to the Invention

In spectroscopy or color measurement applications which characterize the transmission, absorption, emission or reflection of a target material (such as ink on paper, paint on metal, dyes on cloth, etc.), an illumination source must be present, as well as an apparatus to measure the reflected, transmitted or emitted light. One method for providing the illumination is using light emitted from light emitting diodes (LEDs). To adequately characterize the material properties of the target that would be seen by a human observer, illumination over the entire visible wavelength range from 400nm to 700nm is desirable. Individual white or chromatic LEDs and even multiple-LED assemblies, however, often do not provide adequate intensity at all wavelengths in this range.

One known solution for tailoring the emission spectra of a LED to cover the desired illumination range is to use an interference filter in combination with the LED to filter out the unwanted wavelengths. Such an arrangement, however, is not practical where the source (e.g., the LED) does not emit sufficient energy at the desired wavelength. Also, such arrangements can be inefficient for certain applications where much of the energy emissions from the source may be filter out and therefore wasted.

### Summary of the Invention

According to a first aspect of the present invention, there is provided an illumination source comprising: a light emitting device; a first photoluminescent material layer that absorbs photons of light emitted by the light emitting device and re-emits at least a portion of these absorbed photons at longer wavelengths; and, a first filter positioned between the light emitting device and the first photoluminescent material layer, wherein the filter is substantially transmissive of light emitted by the light emitting device and substantially reflective of light emitted by the first photoluminescent material layer.

The light emitting device may comprise one or more LEDs, one or more lasers, one or more laser diodes, one or more lamps, or a combination of these things. The photoluminescent material layer may comprise quantum dot material and/or phosphors.

The photoluminescent material layer absorbs light emitted from the light emitting device and converts the wavelengths of at least a portion of the photons emitted from the light emitting device to longer wavelengths. The illumination source may comprise more than one filter. The filter is substantially transmissive of light emitted by the light emitting device and substantially reflective of light emitted by the photoluminescent material layer, which may be omnidirectional. That way, light emitted from the light emitting device and the photoluminescent material layer may be directed in a common direction that is generally away from the light emitting device. Also, the properties of the photoluminescent material layer may be chosen to achieve a desired emission spectra for the illumination source.

According to various embodiments, the filter may be dielectric filter, comprising layers of material with different refractive indices. Also, multiple photoluminescent material layers may be used, and each may have different light absorption/emission characteristics. Such multiple layers may further facilitate achieving a desired emission spectra for the illumination source. Also, multiple dielectric filters may be employed. In addition, the photoluminescent material layer may be located on an optically transparent substrate that is between the photoluminescent material layer and the filter.

Additionally, optical elements, such as lenses, may be positioned before the filter and/or after the last photoluminescent material layer.

According to a second aspect of the present invention, there is provided an apparatus for measuring a spectroscopic property of a target material comprising: the illumination source of the first aspect for emitting light photons to impinge upon the target material; and, an optical radiation sensing device for detecting at least one of light reflected by or transmitted through the target material.

Thus, the apparatus may comprise any suitable embodiment of the above-described illumination source for emitting light photons to impinge upon the target material and an optical radiation sensing device for detecting light reflected by or transmitted through the target material. The apparatus may, of course, comprise other components.

### Brief Description of the Drawings

Examples of the invention will now be described in detail with reference to the accompanying drawings, in which:
Figures 1, 3-5 and 7-8 are diagrams of an illumination source according to various embodiments of the present invention;
Figure 2 is a diagram of the photoluminescent material layer according to various embodiments of the present invention; and
Figure 6 is a block diagram of a spectroscopic apparatus according to various embodiments of the present invention.

### Detailed Description

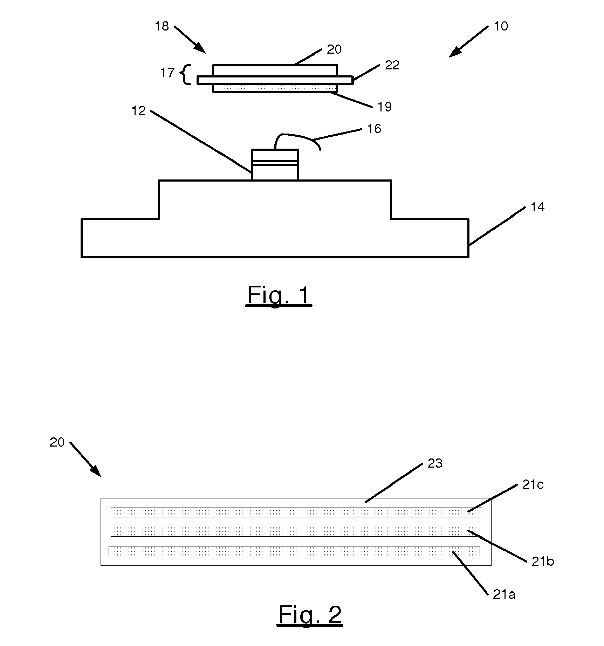

Figure 1 is a diagram of an illumination source according to various embodiments of the present invention. In the illustrated embodiment, the illumination source 10 includes a light emitting device 12 mounted on a header 14. In one embodiment, the light emitting device 12 may be a light emitting diode (LED) including a lead wire 16 that allows the LED to be biased so that it will emit light. The LED may emit photons in the ultraviolet and/or visible portions of the optical spectrum. In other embodiments, the light emitting device 12 may be, for example, one or more lasers, one or more laser diodes, multiple LEDs, one or more lamps, or combinations thereof.

The illumination source 10 illustrated in Figure 1 also includes, in the path of the emitted light from the light emitting device 12, an assembly 18 comprising a photoluminescent material assembly 17 and a filter 19. The photoluminescent material assembly 17 may comprise a photoluminescent material layer 20 placed on a substrate 22. As shown in Figure 1, the filter 19 may be between the substrate 22 and the light emitting device 12. Light emitted from the light emitting device 12 may pass through the filter 19 and the substrate 22, and be absorbed by the photoluminescent material layer 20. The photoluminescent material layer 20 may then emit light at different (e.g., longer) wavelengths than the light absorbed from the light emitting device 12. That is, the light emitting device 12 may optically pump the photoluminescent material layer 20, which may convert the short wavelength photons emitted by the light emitting device 12 into longer wavelength photons. By judicious selection of the photoluminescent material, a desired illumination wavelength profile can be obtained for the illumination source 10.

The filter 19 may be constructed such that the light emitted from the photoluminescent material layer 20, which may be generally omnidirectional due to the properties of the photoluminescent material, is reflected back in a direction generally away from the light emitting device 12. That is, the filter 19 may allow the shorter wavelengths from the light emitting device 12 to pass through to the photoluminescent material layer 20, but reflect back the longer wavelengths emitted from the photoluminescent material layer 20 in a direction generally away from the light emitting device 12. This will tend to increase the efficiency of the illumination source 10 as light emitted from the photoluminescent material layer 20 may be directed in a substantially common direction.

According to various embodiments, the photoluminescent material layer 20 may comprise quantum dot material and/or phosphors incorporated in an inert host material, such as epoxy, resin, gel, etc. Quantum dots have the characteristic that by adjusting the size and chemistry of the quantum dot particles, the optical properties of the material, such as light absorption or light emission, can be tailored to meet desired characteristics. For example, quantum dot material, which may be made from CdSe, CdS or ZnS or other materials, may have absorption in the blue and UV portion of the optical spectrum and emission wavelengths in the visible part of the optical spectrum. Phosphors can also upconvert the light emitted from the light emitting device 12.

The substrate 22 on which the photoluminescent material layer 20 is placed may be optically transparent such that all or most of the light from light emitting device 12 passes through the substrate 22 and impinges on the photoluminescent material layer 20. According to various embodiments, the substrate 20 may be made from glass, such as sapphire glass.

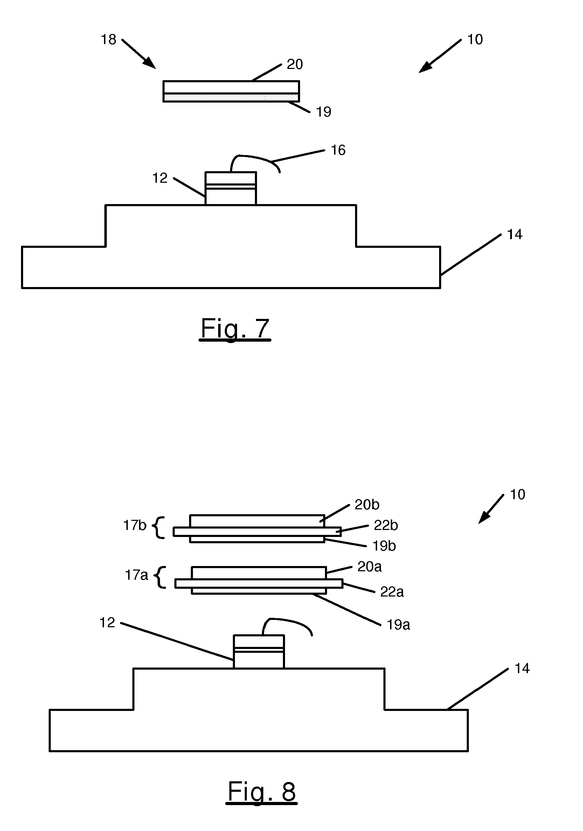

According to other embodiments, as shown in Figure 7, the inert host material comprising the photoluminescent material may be placed on the filter 19, obviating the need for a separate substrate.

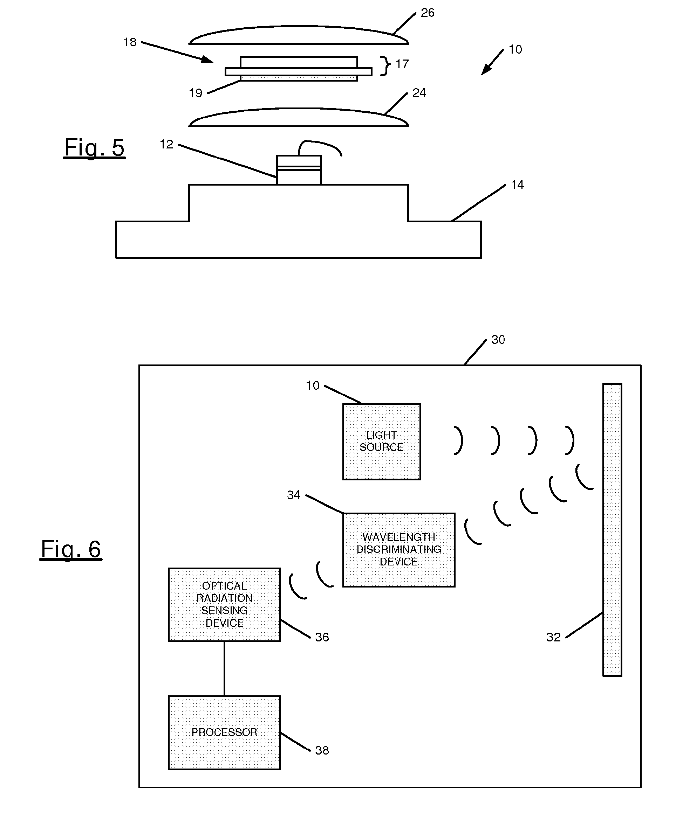

The filter 19 may be any optical device that is capable of allowing all or most of the photons from the light emitting device 12 to pass through to the photoluminescent material layer 20, but which reflects all or most of the longer-wavelength photons emitted from the photoluminescent material layer 20 in a direction generally away from the light emitting device 12. The light then can be collected by an optical component (See Figure 5) that may direct the light from the illumination source 10 usefully onto a target, for example. According to various embodiments, the filter 19 may be a dielectric filter. The dielectric filter may comprise multiple layers of materials with different refractive indices. For instance, the dielectric filter may have alternating layers of SiO₂ and TiO₂, where SiO₂ has a low refractive index and TiO₂ has a high refractive index. By depositing multiple layers of these two materials with specific thicknesses, the filter 19 can be constructed such that it will pass light with wavelengths near a target (or center) wavelength and primarily reflect all other relevant wavelengths. The filter 19 may be constructed such that the target (or center) wavelength corresponds to the emission spectra from the light emitting device 12. Other materials that may be used to construct such a dielectric filter include MgF₂, Ta₂O₅, and SiN. An advantage of using a dielectric filter constructed from such materials is their low loss in the visible spectral region, which may be important in certain spectroscopic applications.

The assembly 18 may be spaced-apart from the light emitting device 12 as shown in Figure 1 and may be supported by a frame (not shown), for example. The assembly 18 and the light emitting device 12 may additionally be encased in a casing (not shown).

In an embodiment where the photoluminescent material layer 20 comprises quantum dot material, the photoluminescent material layer 20 may comprise a composite of different quantum dot intra-layers 21a-c suspended in the host material 23, as shown in Figure 2, each intra-layer 21a-c having different absorption/emission characteristics. For example, the first quantum dot material intra-layer 21 a may convert a portion of the light from the light emitting device 12 to a certain, longer wavelength range, and the second quantum dot material intra-layer 21 b may convert a portion of that light to an even longer wavelength range, and so on. In another embodiment, the second intra-layer 21 b may transmit the longer wavelengths emitted by the first intra-layer 21 a, and may also convert another portion of the shorter wavelengths from the light emitting device 12 to a second, higher wavelength (which may be shorter or longer than the wavelengths emitted by intra-layer 21 a), and so on. In addition, the thicknesses of the various quantum dot material intra-layers 21a-c could also be selected to tune the intensity of the emitted light. This may allow the illumination spectra to be further tailored to have specific features, such as multiple sharp emission peaks or broad band illumination that covers a wide range of the optical spectrum. Also, one or more of the intra-layers 21 a-c may comprise phosphors rather than quantum dot material according to various embodiments.

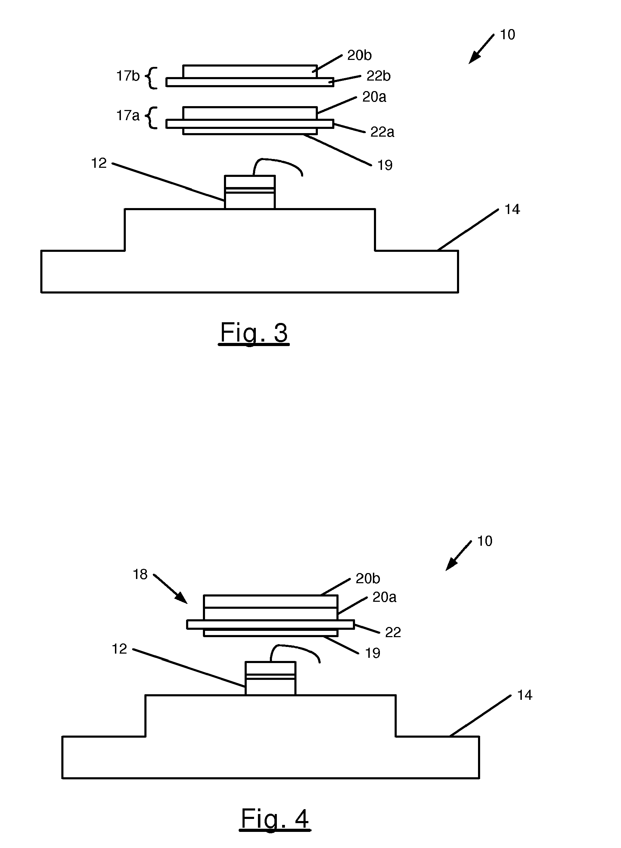

According to various embodiments, the illumination source 10 may comprise multiple photoluminescent material assemblies 17. Figure 3, for example, shows an embodiment of the illumination source 10 comprising two photoluminescent material assemblies 17a-b. The filter 19 may be positioned, as shown in Figure 3, between the first photoluminescent material assembly 17a and the light emitting device 12. The filter 19 may pass light from the light emitting device 12 and reflect emitted light from both of the photoluminescent material assemblies 17a-b in a common direction away from the light emitting device 12.

In such an arrangement, the photoluminescent material layer 20a of one of the assemblies 17a may have different absorption/emission characteristics than the photoluminescent material layer 20b of the other assembly 17b. That way, for example, like the embodiment discussed above where multiple quantum dot material intra-layers 21 are suspended in a common host material, the first photoluminescent material layer 20a may convert a portion of the light from the light emitting device 12 to a certain, longer wavelength range, and the second photoluminescent material layer 20b may convert a portion of that light to an even longer wavelength range, and so on. According to another embodiment, the second photoluminescent material layer 20b may transmit the longer wavelengths emitted from the first photoluminescent layer 20a, and convert another portion of the shorter wavelengths emitted from the light emitting device 12 to another, longer wavelength range, which may be longer or shorter than the wavelengths from the first photoluminescent layer 20a), and so on. The thicknesses of the various photoluminescent material layers 20a,b could also be selected to tune the intensity of the emitted light. In addition, one or more of the photoluminescent material layers 20a,b may comprise a composite of different quantum dot intra-layers or phosphors suspended in the host material, each with different absorption/emission characteristics, as described above in connection with Figure 2.

In other embodiments, rather than using two (or more) substrates 22a,b as in the embodiment of Figure 2, the two (or more) photoluminescent material layers 20a,b may be applied sequentially to a common substrate 22, as shown in Figure 4.

Figure 8 shows the illumination source 10 according to another embodiment. The embodiment of Figure 8 is similar to that of Figure 3, except that the embodiment includes two filters 19a-b, one associated with each photoluminescent material assemblies 17a-b. In such an embodiment, the second filter 19b may be transmissive of light emitted by the first photoluminescent material assembly 17a and the light emitting device 12, and reflective of light emitted by the second photoluminescent material layer 20b. In other embodiments, more than two photoluminescent material assemblies 17 may be used, and some or all of them may have an associated filter 19.

According to other embodiments, as shown in Figure 5, the illumination source 10 may include one or more optical elements, such as a lens 24 positioned between the light emitting device 12 and the assembly 18 and/or a lens 26 after the assembly 18. The lens 24 may collect and focus light from the light emitting device 12 onto the assembly 18, which may provide more efficient use of the light energy from the light emitting device 12. The lens 26 may collimate the light exiting the assembly 18. Also, the lens 26 may collect and focus light emitted from the photoluminescent material on a target sample to be illuminated by the illumination source 10. This may further enhance the efficiency of the illumination source 10.

By careful selection of various options, including the characteristics of the photoluminescent material layer(s) 20 (including the number and characteristics of the intra-layers 21, if any), the number of photoluminescent material layers 20, and the light emission spectral characteristics of the light emitting device 12, a desired emission spectra profile may be produced (or at least approximated). For example, in one embodiment, the light emitting device 12 may emit photons in the ultraviolet portion of the optical spectrum (wavelengths < 400 nm), and the photoluminescent material assembly 17 may convert the pump light to longer wavelengths at sufficient intensities over a broad spectrum, such as wavelengths of 400 nm to 700 nm. According to another embodiment, the light emitting device 12 may emit photons in the blue portion of the optical spectrum (wavelengths between 400 nm and 425 nm), and the photoluminescent material assembly 17 may emit light at sufficient intensities over the 400 nm to 700 nm range.

According to other embodiments, the quantum dot material layer(s) 20 may be chosen such that the emission spectra of the illumination source 10 is limited to a narrow band of wavelengths. As used herein, "narrow band" means less than or equal to 50 nm full width at half maximum (FWHM). That is, when the emission spectra of the illumination source 10 is a narrow band, the difference between the wavelengths at which emission intensity of the illumination source is half the maximum intensity is less than or equal to 50 nm.

According to other embodiments, the photoluminescent material layer(s) 20 may be chosen such that the emission spectra of the illumination source corresponds to a known spectral emission standard such as, for example, incandescent standards (e.g., CIE standard illuminant A), daylight standards (e.g., CIE standard illuminant D65 or D50), fluorescent standards (e.g., CIE standard illuminant F2 or F11), or other defined standards.

One or more of the illumination sources 10 described above may be employed, for example, in a color measurement or spectroscopic apparatus to measure the transmission, absorption, emission and/or reflection properties of a material. Figure 6 is a simplified block diagram of a color measurement or spectroscopic apparatus 30 according to various embodiments of the present invention that comprises one illumination source 10 for illuminating a target material 32, a wavelength discriminating device 34, and an optical radiation sensing device 36. Reflected light from the target material 32 can be filtered by the wavelength discriminating device 34, which may be, for example, a prism, diffraction grating, holographic grating, or assembly of optical filters. The optical radiation sensing device 36, which may comprise, for example, one or a number of photodiodes, may sense the light from the material 32 passing through the wavelength discriminating device 34. A processor 38 in communication with the optical radiation sensing device 36 may determine the transmission, absorption, emission or reflection of the material 32. Also, the system 30 may include other optical components (not shown), such as refractive or diffractive lenses or mirrors, for either directing light from the illumination source 10 onto the material 32 and/or directing light from the material 32 to the wavelength discriminating device 34.

In another embodiment, the wavelength discriminating device 34 and the optical radiation sensing device 36 may be positioned on the opposite side of the target material 32 from the illumination source 10. That way, the optical radiation sensing device 36 may detect light transmitted through the target material 32. Also, in yet another embodiment, the apparatus 30 may comprise one optical radiation sensing device in front of the target 32 for detecting light reflected by the target 32 and a second optical radiation sensing device behind the target for detecting light transmitted through the target 32.

One or more of the illumination sources 10 could be used in other equipment, including, for example, a printing press, an ink jet printer, or other color-based process monitoring equipment.

## Claims

1. An illumination source (10) comprising:
a light emitting device (12);
a first photoluminescent material layer (20) that absorbs photons of light emitted by the light emitting device (12) and re-emits at least a portion of these absorbed photons at longer wavelengths; and,
a first filter (19) positioned between the light emitting device (12) and the first photoluminescent material layer (20), wherein the filter is substantially transmissive of light emitted by the light emitting device and substantially reflective of light emitted by the first photoluminescent material layer.

2. The illumination source (10) of claim 1, wherein the first photoluminescent material layer (20) comprises quantum dot material.

3. The illumination source (10) of claim 1 or claim 2, wherein the first photoluminescent material layer (20) comprises phosphors.

4. The illumination source (10) of any preceding claim, wherein the light emitting device (12) comprises at least one LED.

5. The illumination source (10) of any preceding claim, wherein the light emitting device (12) comprises at least one laser.

6. The illumination source (10) of any preceding claim, wherein the light emitting device (12) comprises at least one laser diode.

7. The illumination source (10) of any preceding claim, wherein the light emitting device (12) comprises a lamp.

8. The illumination source (10) of any preceding claim, further comprising an optically transparent substrate (22), wherein the first photoluminescent material layer (20) is located on the substrate (22), and wherein the substrate (22) is between the first photoluminescent material layer (20) and the first filter (19).

9. The illumination source of any preceding claim, wherein the first photoluminescent material layer (20) is located on the first filter (19).

10. The illumination source (10) of any preceding claim, wherein the first filter (19) comprises a dielectric filter.

11. The illumination source (10) of any preceding claim, wherein the emission spectra of the illumination source (10) corresponds to an adopted illumination standard.

12. The illumination source (10) of claim 11, wherein the adopted illumination standard is selected from the group consisting of an incandescent illumination standard, a daylight illumination standard and a fluorescent illumination standard.

13. The illumination source (10) of any preceding claim, wherein the emission spectra of the illumination source (10) is within a narrow band of wavelengths.

14. The illumination source (10) of any preceding claim, further comprising a lower lens (24) between the light emitting device (12) and the filter (14).

15. The illumination source (10) of any preceding claim, further comprising an upper lens (26), such that the first photoluminescent material layer (20) is between the light emitting device (12) and the upper lens (26).

16. The illumination source (10) of any preceding claim, wherein the first photoluminescent material layer (20) comprises a plurality of photoluminescent material intra-layers (21 a,21 b,21 c) each having different light emission characteristics.

17. The illumination source (10) of any preceding claim, comprising one or more further photoluminescent material layers (20b) each having different light absorption/emission characteristics.

18. The illumination source (10) of claim 16 or claim 17, comprising one or more further filters (19b) that are transmissive of light emitted by the light emitting device (12) and reflective of light emitted by one or more of the photoluminescent material layers (20a,20b) and intra-layers (21a,21b,21c).

19. The illumination source (10) according to any of claims 1 to 16, wherein the source further comprises a second photoluminescent material layer (20b) positioned such that the first photoluminescent material layer (20a) is between the second photoluminescent material layer (20b) and the light emitting device (12) and wherein the first filter (19) is also substantially reflective of light emitted by the second photoluminescent material layer (20b).

20. The illumination source (10) of claim 19, wherein the second photoluminescent material layer (20b) absorbs photons of light re-emitted by the first photoluminescent material layer (20a) and re-emits at least a portion of these absorbed photons at even longer wavelengths.

21. The illumination source (10) of claim 19, wherein the second photoluminescent material layer (20b) is substantially transmissive of light re-emitted by the first photoluminescent material layer (20a), and wherein the second photoluminescent material layer (20b) absorbs photons of light emitted by the light emitting device and re-emits at least a portion of these photons at longer wavelengths which are different to the wavelengths of the photons of light re-emitted by the first photoluminescent material layer (20a).

22. The illumination source (10) of any of claims 18 to 21, further comprising a second filter (19b) positioned between the first photoluminescent material layer (20a) and the second photoluminescent material layer (20b), wherein the second filter (19b) is substantially transmissive of light emitted by the light emitting device (12) and the first photoluminescent material layer (20a), and wherein the second filter (19b) is substantially reflective of light re-emitted by the second photoluminescent material layer (20b).

23. An apparatus (30) for measuring a spectroscopic property of a target material (32) comprising:
the illumination source (10) of any preceding claim for emitting light photons to impinge upon the target material (32); and,
an optical radiation sensing device (36) for detecting at least one of light reflected by or transmitted through the target material (32).
